# EUROPEAN PATENT APPLICATION

(11) **EP 3 193 377 A1**
(43) Date of publication of application: **19.07.2017**
(21) Application number: 15840555.5
(22) Date of filing: 16.07.2015
(51) Int. Cl.: H01L 31/048, C08K 5/14, C08L 23/04, C09K 3/10

(54) **SEALING MATERIAL COMPOSITION FOR SOLAR CELLS, SEALING MATERIAL LAYER FOR SOLAR CELLS USING SAME, AND SOLAR CELL MODULE**

(30) Priority: 08.09.2014 JP 2014182209
(71) Applicant: Nitto Denko Corporation, Ibaraki-shi, Osaka 567-8680 (JP)
(72) Inventor: ONOUCHI,Hisanari, Ibaraki-shi Osaka 567-8680 (JP); KITAHARA,Tatsuya, Ibaraki-shi Osaka 567-8680 (JP); KAWAMITSU,Shoichi, Ibaraki-shi Osaka 567-8680 (JP)
(74) Representative: Grünecker Patent- und Rechtsanwälte PartG mbB
(86) International application number: PCT/JP2015/070394
(87) International publication number: WO 2016/039013

(57) **Abstract**

Provided are a encapsulant composition that is for solar cells and can reduce the time required for a lamination process and improve light stability and resistance to moisture and heat, and a solar cell encapsulant layer and a solar cell module, each produced with the composition, wherein the composition includes an ethylenic copolymer and an organic peroxide having a peroxyester structure represented by formula (1) or (2) 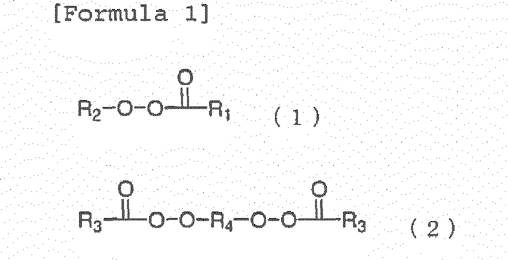 wherein R₁, R₂, R₃, and R₄ each independently represent an optionally substituted alkyl group of 1 to 18 carbon atoms or an optionally substituted aryl group of 5 to 18 carbon atoms.

## Description

### BACKGROUND OF THE INVENTION

### Field of the Invention

The invention relates to a encapsulant composition particularly suitable for solar cell applications. The invention also relates to a solar cell encapsulant layer produced with the composition and to a solar cell module having the encapsulant layer.

### Description of the Related Art

In a solar cell module, the power generation cell is encapsulated and protected in a encapsulant sheet made of a resin material. Such a solar cell module is produced through a lamination process including melting and pressing a encapsulant sheet under heating, in which an organic peroxide added to the encapsulant sheet undergoes thermal decomposition to produce radicals, which allows a crosslinking reaction. Various compositions containing organic peroxides and other stabilizers have been studied to reduce the lamination time and prevent bubble generation and yellowing during outdoor use.

For example, Patent Document 1 proposes an organic peroxide having a peroxyketal structure, which is intended to reduce the time required for lamination and to prevent bubble generation. However, this organic peroxide generates radicals at a low thermal decomposition temperature, which causes a problem in that the radicals are generated in a film formation process at about 110°C so that gelation can occur. To avoid the problem of gelation, it is necessary to perform heating at a sufficiently low temperature for a short period of time in the film formation, which significantly affects the productivity of the encapsulant sheet. In particular, as a result of studies, the inventors have found that the one-minute half-life temperature should be higher than 155°C and that when the heating is performed at a temperature lower than that, the encapsulant sheet obtained by the film formation can suffer from a high degree of yellowing.

For example, Patent Document 2 proposes that a mixture of a compound having a dialkyl peroxyether structure and a compound having a peroxycarbonate structure is subjected to heat press bonding for about 15 minutes. As a result of studies, however, the inventors have found that even after the heat press bonding under the proposed conditions, the added organic peroxide still remains in solar cell modules, so that the modules have low light stability and can undergo yellowing upon humidification and heating. The consumption of these organic peroxides requires heating at high temperature for a sufficient period of time, which makes it difficult to shorten the lamination process.

### Prior Art Documents

### Patent Documents

Patent Document 1: JP-A-2011-252127
Patent Document 2: Japanese Patent No. 4616388

### SUMMARY OF THE INVENTION

In light of these circumstances, it is an object of the invention to provide a encapsulant composition that is for a solar cell and can reduce the time required for a lamination process and improve light resistance and resistance to moisture and heat.

It is another object of the invention to provide a solar cell encapsulant layer made from the encapsulant composition for a solar cell and to provide a solar cell module using the solar cell encapsulant layer.

As a result of earnest studies to solve the above problems, the inventors have accomplished the invention based on findings that the objects can be achieved with the encapsulant composition for a solar cell, the solar cell encapsulant layer produced therewith, and the solar cell module, each shown below.

The invention is directed to a encapsulant composition for a solar cell, the encapsulant composition including an ethylenic copolymer and an organic peroxide having a peroxyester structure represented by formula (1) or (2) 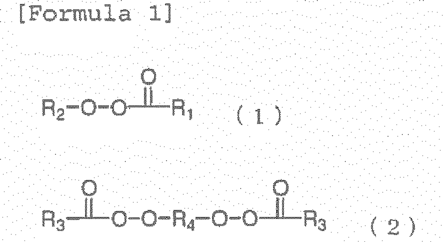 wherein R₁, R₂, R₃, and R₄ each independently represent an optionally substituted alkyl group of 1 to 18 carbon atoms or an optionally substituted aryl group of 5 to 18 carbon atoms.

The use of the encapsulant composition of the invention for a solar cell makes it possible to perform a lamination process in a shorter time than that required conventionally and to form a solar cell encapsulant layer with improved light resistance and improved resistance to moisture and heat. In general, organic peroxides, which are in a highly oxidized state, tend to oxidize and degrade organic materials around them. In solar cell modules, therefore, organic peroxides remaining after lamination will be a cause of defects such as yellowing. As a result of earnest studies, the inventors have found that it is necessary to select an organic peroxide that not only can be efficiently decomposed by heating to function as a crosslinking agent for an ethylenic copolymer but also has sufficiently low oxidizability. On the other hand, the inventors have found that organic peroxides should have a one-minute half-life temperature of 155°C or higher so that crosslinking can be prevented during film formation and have also found that organic peroxides should have a one-minute half-life temperature of 170°C or lower so that they can be sufficiently consumed during heat press bonding in a lamination process. As a result of studies, the inventors have also found that in particular, some organic peroxides with an alkyl peroxyester structure have relatively low oxidizability and can be used to form encapsulant sheets with good properties such as resistance to yellowing. In addition, as a result of the molecular design and control of such an alkyl structure, the inventors have successfully found organic peroxides having a one-minute half-life temperature in the desired range.

In the encapsulant composition of the invention for a solar cell, R₁ and R₃ in formulae (1) and (2) are preferably optionally substituted alkyl groups of 1 to 18 carbon atoms. The use of this organic peroxide makes it possible to more easily reduce the time required for a lamination process and to form a solar cell encapsulant layer with improved light resistance and improved resistance to moisture and heat.

In the encapsulant composition of the invention for a solar cell, R₂ in formula (1) is preferably a tert-butyl group or a tert-hexyl group. The use of this organic peroxide makes it possible to more easily reduce the time required for a lamination process and to form a solar cell encapsulant layer with improved light resistance and improved resistance to moisture and heat.

In the encapsulant composition of the invention for a solar cell, R₄ in formula (2) is preferably an optionally substituted alkyl group of 1 to 18 carbon atoms. The use of this organic peroxide makes it possible to reduce the time required for a lamination process and to form a solar cell encapsulant layer with improved light resistance and improved resistance to moisture and heat.

The encapsulant composition of the invention for a solar cell preferably includes 100 parts by weight of the ethylenic copolymer and 0.01 to 3 parts by weight of the organic peroxide. This feature makes it possible to more reliably reduce the time required for a lamination process and to form a solar cell encapsulant layer with improved light resistance and improved resistance to moisture and heat.

The encapsulant composition of the invention for a solar cell preferably further includes 0.001 to 0.5 parts by weight of an antioxidant based on 100 parts by weight of the ethylenic copolymer. This feature makes it possible to more reliably reduce the time required for a lamination process and to form a solar cell encapsulant layer with improved light resistance and improved resistance to moisture and heat.

In the encapsulant composition of the invention for a solar cell, the antioxidant preferably has an optionally substituted hydroxytoluene skeleton. This feature makes it possible to more effectively reduce the time required for a lamination process and to form a solar cell encapsulant layer with improved light resistance and improved resistance to moisture and heat.

The encapsulant composition of the invention for a solar cell may contain an ultraviolet-absorbing compound. When the ultraviolet-absorbing compound is used, an additional function such as the function of suppressing ultraviolet-induced degradation or the function of converting a wavelength can be imparted to the encapsulant composition, so that the resulting encapsulant composition can form a solar cell-encapsulating multifunctional layer.

On the other hand, the invention is directed to a solar cell encapsulant layer including a product made from the encapsulant composition. The solar cell encapsulant layer, which is made from the encapsulant composition, allows a lamination process to be performed in a shorter time than that required conventionally and can have improved light resistance and improved resistance to moisture and heat.

The invention is also directed to a solar cell module including the solar cell encapsulant layer including a product made from the encapsulant composition for a solar cell. The solar cell module, which has the solar cell encapsulant layer, allows a lamination process to be performed in a shorter time than that required conventionally and can have improved light resistance and improved resistance to moisture and heat.

In the solar cell module of the invention, the solar cell is preferably a crystalline silicon solar cell, an amorphous silicon solar cell, a microcrystalline silicon solar cell, a thin-film silicon solar cell, a heterojunction solar cell, a multi-junction solar cell, a cadmium sulfide/cadmium telluride solar cell, a CIS thin-film solar cell, a CIGS thin-film solar cell, a CZTS thin-film solar cell, a group III-V solar cell, a dye-sensitized solar cell, or an organic semiconductor solar cell.

### BRIEF DESCRIPTION OF THE DRAWINGS

Fig. 1 is a diagram showing an example of a solar cell module using the solar cell encapsulant layer of the invention;
Fig. 2 is a diagram showing another example of a solar cell module using the solar cell encapsulant layer of the invention; and
Fig. 3 is a diagram showing a further example of a solar cell module using the solar cell encapsulant layer of the invention.

### DETAILED DESCRIPTION OF THE PREFERRED EMBODIMENTS

Hereinafter, embodiments of the invention will be described.

The encapsulant composition of the invention for a solar cell includes an ethylenic copolymer and an organic peroxide having a peroxyester structure represented by formula (1) or (2) below. 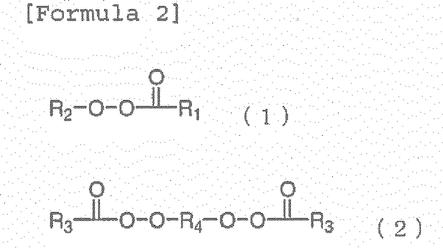 In the formulae, R₁, R₂, R₃, and R₄ each independently represent an optionally substituted alkyl group of 1 to 18 carbon atoms or an optionally substituted aryl group of 5 to 18 carbon atoms.

### Encapsulant composition for solar cell

The encapsulant composition of the invention for a solar cell includes an ethylenic copolymer and an organic peroxide having a peroxyester structure represented by formula (1) or (2) below. 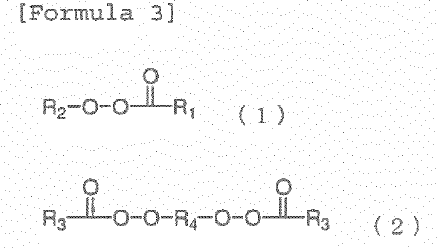 In the formulae, R₁, R₂, R₃, and R₄ each independently represent an optionally substituted alkyl group of 1 to 18 carbon atoms or an optionally substituted aryl group of 5 to 18 carbon atoms.

In the invention, the ethylenic copolymer maybe any known appropriate ethylenic copolymer. As used herein, the term "ethylenic copolymer" refers to a polymer including a constitutional unit derived from a monomer having an ethylenic structure (a carbon-carbon double bond), which is intended to include a polymer of the monomer only, a copolymer having a main constitutional unit derived from the monomer, and the like. In the invention, the ethylenic copolymer also encompasses a homopolymer of the monomer. As used herein, the term "main constitutional unit" means that the weight content of the unit in the copolymer is 50% by weight or more.

The synthesis of the ethylenic copolymer by copolymerization reaction may be performed using a known appropriate polymer synthesis technique. Such a technique may be, for example, random copolymerization, graft polymerization, cross-polymerization, or block copolymerization of one or more monomers. The copolymerization reaction may be radical polymerization (such as cationic polymerization, anionic polymerization, or any living polymerization), ionic polymerization, addition polymerization (polyaddition), condensation polymerization (polycondensation), cyclization polymerization, ring-opening polymerization, or the like. An organic solvent system, an aqueous solution system, an emulsion state, a suspension state, or other synthetic processes may be appropriately used in the copolymerization reaction.

The monomer may be, for example, acrylic acid, methacrylic acid, an alkyl (meth)acrylate such as methyl acrylate, methyl methacrylate, ethyl acrylate, ethyl methacrylate, butyl acrylate, butyl methacrylate, 2-ethylhexyl acrylate, or 2-ethylhexyl methacrylate, cyclohexyl acrylate, cyclohexyl methacrylate, phenyl acrylate, phenyl methacrylate, benzyl acrylate, benzyl methacrylate, styrene, α-methylstyrene, vinyltoluene, acrylamide, diacetone acrylamide, acrylonitrile, methacrylonitrile, maleic anhydride, phenylmaleimide, cyclohexylmaleimide, or the like. The monomer may also be a hydroxyl-, epoxy-, or halogen-substituted alkyl (meth)acrylate. The monomer may also be vinyl acetate or an α-olefin monomer such as 1-hexene or 1-octene. The alkyl group constituting the ester moiety of the (meth)acrylate preferably has 1 to 18 carbon atoms, more preferably 1 to 8 carbon atoms. In particular, vinyl acetate or an α-olefin monomer is often added as the monomer. These compounds may be used alone or in combination of two or more.

In the copolymerization reaction to form the ethylenic copolymer, a fluorescent dye compound may be copolymerized, so that an ultraviolet-absorbing function or a wavelength-converting function can also be imparted to the encapsulant layer. In this case, the fluorescent dye compound component may make up 0.01 to 20% by weight, 0.02 to 15% by weight, 0.05 to 10% by weight, 0.08 to 6% by weight, or 0.1 to 4% by weight of the copolymer. In these ranges, a good balance can be achieved between the wavelength-converting function of the fluorescent dye compound and the reduction of the process time, the shaping, the working, or the durability after the shaping.

The ethylenic copolymer may have a number average molecular weight (Mn) of 3 × 10³ to 3 × 10⁶, 1 × 10⁴ to 1 × 10⁶, 2 × 10⁴ to 5 × 10⁵, or 4 × 10⁴ to 2 × 10⁵. The number average molecular weight is based on GPC (gel permeation chromatography) measurement (to determine the polystyrene-equivalent molecular weight). The copolymer with a molecular weight in these ranges can be easily shaped and worked and has good durability after shaping.

The ethylenic copolymer may have a weight average molecular weight of 1 × 10⁴ to 9 × 10⁶, 2 × 10⁴ to 2 × 10⁶, × 10⁴ to 1 × 10⁶, or 1 × 10⁵ to 8 × 10⁵. The weight average molecular weight is based on GPC measurement (to determine the polystyrene-equivalent molecular weight). The copolymer with a molecular weight in these ranges can be easily shaped and worked and has good durability after shaping.

The ethylenic copolymer preferably has a melting temperature (Tm) of 50 to 130°C, 55 to 120°C, 60 to 110°C, or 65 to 100°C. The melting temperature (Tm °C) is measured with a differential scanning calorimeter (DSC). The copolymer with a melting temperature in these ranges can be easily shaped and worked and has good durability after shaping.

The process of performing the copolymerization reaction may include, for example, adding a thermal polymerization initiator or a photopolymerization initiator, to a monomer or monomers and subjecting the mixture to polymerization by heating or exposure to light.

The thermal polymerization initiator may be a known appropriate peroxide. Examples of the polymerization initiator include 2,5-dimethylhexane-2,5-dihydroperoxide, 2,5-dimethyl-2,5-di(tert-butylperoxy)hexane-3, di-tert-butyl peroxide, dicumyl peroxide, 2,5-dimethyl-2,5-di(tert-butylperoxy)hexane, dicumyl peroxide, α,α'-bis(tert-butylperoxyasopropyl)benzene, n-butyl-4,4-bis(tert-butylperoxy)butane, 2,2-bis(tert-butylperoxy)butane, 1,1-bis(tert-butylperoxy)cyclohexane, 1,1-bis(tert-butylperoxy)-3,3,5-trimethylcyclohexane, tert-butylperoxybenzoate, benzoyl peroxide, and the like. These compounds may be used alone or in combination of two or more.

The thermal polymerization initiator may be used in an amount of, for example, 0.1 to 5 parts by weight based on 100 parts by weight of the monomer or monomers.

The photopolymerization initiator may be a known appropriate photoinitiator capable of producing a free radical upon exposure to ultraviolet or visible light. Examples of the photopolymerization initiator include benzoin ethers such as benzoin methyl ether, benzoin ethyl ether, benzoin propyl ether, benzoin isobutyl ether, and benzoin phenyl ether; benzophenones such as benzophenone, N,N'-tetramethyl-4,4'-diaminobenzophenone (Michler's ketone), and N,N'-tetraethyl-4,4'-diaminobenzophenone; benzyl ketals such as benzyl dimethyl ketal (IRGACURE 651 manufactured by Ciba Specialty Chemicals, Japan) and benzyl diethyl ketal; acetophenones such as 2,2-dimethoxy-2-phenylacetophenone, p-tert-butyldichloroacetophenone, and p-dimethylaminoacetophenone; xanthones such as 2,4-dimethylthioxanthone and 2,4-diisopropylthioxanthone; hydroxycyclohexyl phenyl ketone (IRGACURE 184 manufactured by Ciba Specialty Chemicals); 1-(4-isopropylphenyl)-2-hydroxy-2-methylpropan-1-one (DAROCUR 1116 manufactured by Ciba Specialty Chemicals, Japan) ; 2-hydroxy-2-methyl-1-phenylpropan-1-one (DAROCUR 1173 manufactured by Merck KGaA), and the like. These may be used alone or in combination of two or more.

The photopolymerization initiator may also be a combination of a 2,4,5-triarylimidazole dimer and 2-mercaptobenzoxazole, leuco crystal violet, tris(4-diethylamino-2-methylphenyl)methane, or the like. A known appropriate additive such as a tertiary amine (e.g., triethanolamine for benzophenone) may also be used.

The photopolymerization initiator may be used in an amount of, for example, 0.1 to 5 parts by weight based on 100 parts by weight of the monomer or monomers.

In the invention, examples of the ethylenic copolymer include an ethylenic copolymer including a vinyl acetate unit and an α-olefin unit, polyethylene terephthalate, poly(meth)acrylate, polyvinyl acetate, polyethylenetetrafluoroethylene, and the like. The ethylenic copolymer may further include an additional copolymerized constitutional unit or units. These ethylenic copolymers may be used alone or in combination of two or more.

Examples of the poly (meth) acrylate include polyacrylate and polymethacrylate, such as (meth) acrylate resins. Examples of the polyolefin resin include polyethylene, polypropylene, polybutadiene, and the like. Examples of the polyvinyl acetate include polyvinyl formal, polyvinyl butyral (PVB resin), modified PVB, and the like.

Examples of the monomer used to form the (meth) acrylate resin include alkyl (meth)acrylates such as methyl acrylate, methyl methacrylate, ethyl acrylate, ethyl methacrylate, butyl acrylate, butyl methacrylate, 2-ethylhexyl acrylate, and 2-ethylhexyl methacrylate, cyclohexyl acrylate, cyclohexyl methacrylate, phenyl acrylate, phenyl methacrylate, benzyl acrylate, benzyl methacrylate, and the like. Hydroxyl-, epoxy-, or halogen-substituted alkyl (meth) acrylates may also be used. These compounds may be used alone or in combination of two or more.

The alkyl group of the ester moiety of the (meth) acrylate preferably has 1 to 18 carbon atoms, more preferably 1 to 8 carbon atoms.

The (meth)acrylate resin may be a copolymer that is produced using the (meth) acrylate (s) and an unsaturated monomer or monomers copolymerizable therewith.

Examples of the unsaturated monomer include unsaturated organic acids such as methacrylic acid and acrylic acid, styrene, α-methylstyrene, acrylamide, diacetone acrylamide, acrylonitrile, methacrylonitrile, maleic anhydride, phenylmaleimide, cyclohexylmaleimide, and the like. These unsaturated monomers may be used alone or in combination of two or more.

Examples of the (meth) acrylate that are preferably used include methyl acrylate, ethyl acrylate, isobutyl acrylate, n-butyl acrylate, 2-ethylhexyl acrylate, methyl methacrylate, isobutyl methacrylate, n-butyl methacrylate, 2-ethylhexyl methacrylate, and alkyl (meth)acrylates substituted with a functional group or groups. In view of durability or versatility, methyl methacrylate is a more preferred example.

The copolymer preferably includes, as a monomer unit, at least one of vinyl acetate or an α-olefin such as 1-hexene or 1-octene. The copolymer also preferably includes both an α-olefin and vinyl acetate as monomer units. This composition more reliably allows the copolymer to have a high level of workability, optical transparency, and long-term reliability.

The ethylenic copolymer may also be, for example, a (meth)acrylate-styrene copolymer, an ethylene-vinyl acetate copolymer, or the like. In view of moisture resistance, versatility, and cost, an ethylene-vinyl acetate copolymer is particularly preferred, and in view of durability and surface hardness, a (meth) acrylate copolymer is particularly preferred. In each of the above viewpoints, an ethylene-vinyl acetate copolymer is preferably used in combination with a (meth)acrylate copolymer.

On the basis of 100 parts by weight of the ethylene-vinyl acetate copolymer, the content of the vinyl acetate monomer unit in the ethylene-vinyl acetate copolymer is preferably from 10 to 35 parts by weight, more preferably from 20 to 30 parts by weight. This content is preferred also in view of uniform dispersibility of a rare earth metal complex or the like in the matrix resin.

The ethylene-vinyl acetate copolymer, the ethylene-α-olefin copolymer, or the like may be used as an optically-transparent ethylenic copolymer. In this case, an appropriate commercially-available product may be used as the copolymer. Examples of commercially available products of the ethylene-vinyl acetate copolymer include Ultrathene (manufactured by Tosoh Corporation), EVAFLEX (manufactured by DUPONT-MITSUI POLYCHEMICALS CO., LTD), Suntec EVA (manufactured by Asahi Kasei Chemicals Corporation), UBE EVA Copolymer (manufactured by UBE-MARUZEN POLYETHYLENE), EVATATE (manufactured by Sumitomo Chemical Company, Limited), Novatec EVA (manufactured by Japan Polyethylene Corporation), SUMITATE (manufactured by Sumitomo Chemical Company, Limited), Nipoflex (manufactured by Tosoh Corporation), and the like. Examples of commercially available products of the ethylene-α-olefin copolymer include ENGAGE, AFFINITY, and INFUSE (all manufactured by The Dow Chemical Company), TAFMER (manufactured by Mitsui Chemicals, Inc.), Kernel (manufactured by Japan Polyethylene Corporation), and the like.

In the process of forming the ethylenic copolymer, a crosslinking monomer may be added to form a crosslinked structure-containing resin.

Examples of the crosslinking monomer include cyclopentenyl (meth)acrylate, tetrahydrofurfuryl (meth)acrylate, benzyl (meth)acrylate, compounds obtained by reaction of polyhydric alcohols with α,β-unsaturated carboxylic acids (such as polyethylene glycol di(meth)acrylate (with 2 to 14 ethylene groups), trimethylolpropane di(meth)acrylate, trimethylolpropane tri(meth)acrylate, trimethylolpropane ethoxytri(meth)acrylate, trimethylolpropane propoxytri(meth)acrylate, tetramethylolmethane tri (meth) acrylate, tetramethylolmethane tetra(meth)acrylate, polypropylene glycol di(meth)acrylate (with 2 to 14 propylene groups), dipentaerythritol penta(meth)acrylate, dipentaerythritol hexa(meth)acrylate, bisphenol A polyoxyethylene di(meth)acrylate, bisphenol A dioxyethylene di(meth)acrylate, bisphenol A trioxyethylene di(meth)acrylate, and bisphenol A decaoxyethylene di (meth) acrylate), compounds obtained by addition reaction of α,β-unsaturated carboxylic acids with glycidyl group-containing compounds (such as trimethylolpropane triglycidyl ether triacrylate and bisphenol A diglycidyl ether diacrylate), esters between polycarboxylic acids (such as phthalic anhydride) and compounds having hydroxyl and ethylenic unsaturated groups (such as β-hydroxyethyl (meth)acrylate), alkyl acrylates or alkyl methacrylates (such as methyl (meth)acrylate, ethyl (meth)acrylate, butyl (meth)acrylate, and 2-ethylhexyl (meth)acrylate), urethane (meth)acrylates (such as a product of reaction of tolylene diisocyanate and 2-hydroxyethyl (meth)acrylate and a product of reaction of trimethylhexamethylene diisocyanate, cyclohexane dimethanol, and 2-hydroxyethyl (meth)acrylate), and the like. These crosslinking monomers may be used alone or in combination of two or more. In particular, the crosslinking monomer is preferably trimethylolpropane tri(meth)acrylate, dipentaerythritol tetra(meth)acrylate, dipentaerythritol hexa(meth)acrylate, or bisphenol A polyoxyethylene dimethacrylate.

When the crosslinking monomer is used to form the ethylenic copolymer, for example, the crosslinking monomer may be mixed with a thermal polymerization initiator or a photopolymerization initiator and then subjected to polymerization and crosslinking by heating or exposure to light to form a crosslinked structure.

The thermal polymerization initiator may be a known appropriate peroxide. Examples of the thermal polymerization initiator include 2,5-dimethylhexane-2,5-dihydroperoxide, 2,5-dimethyl-2,5-di(tert-butylperoxy)hexane-3, di-tert-butyl peroxide, dicumyl peroxide, 2,5-dimethyl-2,5-di(tert-butylperoxy)hexane, dicumyl peroxide, α,α'-bis(tert-but.ylperoxyisopropyl)benzene, n-butyl-4,4-bis(tert-butylperoxy)butane, 2,2-bis(tert-butylperoxy)butane, 1,1-bis(tert-butylperoxy)cyclohexane, 1,1-bis(tert-butylperoxy)-3,3,5-trimethylcyclohexane, tert-butylperoxybenzoate, benzoyl peroxide, and the like. These compounds may be used alone or in combination of two or more.

The thermal polymerization initiator may be used in an amount of, for example, 0.1 to 5 parts by weight based on 100 parts by weight of the ethylenic copolymer.

The photopolymerization initiator may be a known appropriate photoinitiator capable of producing a free radical upon exposure to ultraviolet or visible light. Examples of the photopolymerization initiator include benzoin ethers such as benzoin methyl ether, benzoin ethyl ether, benzoin propyl ether, benzoin isobutyl ether, and benzoin phenyl ether; benzophenones such as benzophenone, N,N'-tetramethyl-4,4'-diaminobenzophenone (Michler's ketone), and N,N'-tetraethyl-4,4'-diaminobenzophenone; benzyl ketals such as benzyl dimethyl ketal (IRGACURE 651 manufactured by Ciba Specialty Chemicals, Japan) and benzyl diethyl ketal; acetophenones such as 2,2-dimethoxy-2-phenylacetophenone, p-tert-butyldichloroacetophenone, and p-dimethylaminoacetophenone; xanthones such as 2,4-dimethylthioxanthone and 2,4-diisopropylthioxanthone; hydroxycyclohexyl phenyl ketone (IRGACURE 184 manufactured by Ciba Specialty Chemicals); 1-(4-isopropylphenyl)-2-hydroxy-2-methylpropan-1-one (DAROCUR 1116 manufactured by Ciba Specialty Chemicals, Japan) ; 2-hydroxy-2-methyl-1-phenylpropan-1-one (DAROCUR 1173 manufactured by Merck KGaA), and the like. These may be used alone or in combination of two or more.

The photopolymerization initiator may also be a combination of a 2,4,5-triarylimidazole dimer and 2-mercaptobenzoxazole, leuco crystal violet, tris(4-diethylamino-2-methylphenyl)methane, or the like. Any known appropriate additive such as a tertiary amine (e.g., triethanolamine for benzophenone) may also be used.

The photopolymerization initiator may be used in an amount of, for example, 0.1 to 5 parts by weight based on 100 parts by weight of the ethylenic copolymer.

A fluorescent dye compound may be used as a monomer and copolymerized into the ethylenic copolymer, so that an ultraviolet-absorbing function or a wavelength-converting function can also be imparted to the encapsulant layer. In this case, the ethylenic copolymer can be a luminescent ethylenic copolymer having the function of converting the wavelength of incident light to a longer wavelength.

The ethylenic copolymer in which the fluorescent dye compound is copolymerized preferably has a maximum absorption wavelength of 300 to 410 nm, 330 to 370 nm, or 340 to 360 nm.

The ethylenic copolymer in which the fluorescent dye compound is copolymerized preferably has a maximum fluorescence wavelength of 400 to 560 nm, 405 to 490 nm, or 410 to 470 nm.

The ethylenic copolymer in which the fluorescent dye compound is copolymerized preferably has an absorbance of 0.5 to 6, more preferably 0.8 to 4, even more preferably 1 to 3. The absorbance is the value calculated according to the Lambert-Beer law.

The ethylenic copolymer preferably has a refractive index in the range of 1.4 to 1.7, 1.45 to 1.65, or 1.45 to 1.55. In some embodiments, the ethylenic copolymer has a refractive index of 1.5.

The encapsulant composition of the invention for a solar cell contains the ethylenic copolymer. The ethylenic copolymer may be used as a main component to form the composition. Alternatively, an additional matrix resin may be used as a main component in combination with the ethylenic copolymer to form the composition.

An optically transparent resin is preferably used as the additional matrix resin. Examples of the additional matrix resin include polyimide, amorphous polycarbonate, siloxane sol-gel, polyurethane, polystyrene, polyether sulfone, polyarylate, epoxy resin, silicone resin, and the like. One of these matrix resins may be used in combination with the ethylenic copolymer, or a mixture of two or more of these matrix resins may be used in combination with the ethylenic copolymer.

The encapsulant composition can be formed by subjecting the ethylenic copolymer and the additional matrix resin to mixing, dispersing, or other processes. The method to be used may include, for example, melting and kneading the materials to form the composition or mixing the materials in a solution (and optionally casting the mixture) and then removing the solvent to form the composition. The ethylenic copolymer may only be used as the matrix material.

The ethylenic copolymer may be used as a main component to form the encapsulant composition of the invention for a solar cell. Alternatively, the additional matrix resin may be used as a main component in combination with the ethylenic copolymer to form the composition. When the ethylenic copolymer is used as a main component, the content of the ethylenic copolymer may be 50 to 100% by weight, 55 to 95% by weight, 60 to 90% by weight, 75 to 85% by weight, or 70 to 80% by weight. When the additional matrix resin is used as a main component in combination with the ethylenic copolymer, the content of the ethylenic copolymer may be, for example, 0.01 to 49.9% by weight, 0.1 to 45% by weight, 1 to 40% by weight, 2 to 35% by weight, 3 to 30% by weight, 5 to 25% by weight, 8 to 20% by weight, or 10 to 15% by weight.

In the invention, the organic peroxide is characterized by having a peroxyester structure represented by formula (1) or (2) below. 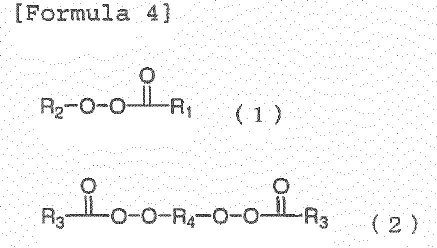 In the formulae, R₁, R₂, R₃, and R₄ each independently represent an optionally substituted alkyl group of 1 to 18 carbon atoms or an optionally substituted aryl group of 5 to 18 carbon atoms.

In the organic peroxide, R₁, R₂, R₃, and R₄ each independently represent an optionally substituted alkyl group of 1 to 18 carbon atoms or an optionally substituted aryl group of 5 to 18 carbon atoms. The alkyl group may have 1 to 18 carbon atoms, 2 to 8 carbon atoms, 3 to 6 carbon atoms, or 4 to 5 carbon atoms. The aryl group may have 5 to 18 carbon atoms, 6 to 12 carbon atoms, or 8 to 10 carbon atoms.

As a non-limiting example, R₁, R₂, R₃, and R₄ may be each independently ethyl, propyl, isopropyl, butyl, isobutyl, sec-butyl, tert-butyl, pentyl, hexyl, tert-hexyl, heptyl, 2-ethylhexyl, octyl, phenyl, methylphenyl, dimethylphenyl, trimethylphenyl, tetramethylphenyl, ethylphenyl, diethylphenyl, n-propylphenyl, di-n-propylphenyl, isopropylphenyl, diisopropylphenyl, n-butylphenyl, di-n-butylphenyl, isopropylphenyl, sec-butylphenyl, di-sec-butylphenyl, tert-butylphenyl, di-tert-butylphenyl, diisopropylphenyl, naphthyl, biphenyl, phenanthryl, pyrrolyl, furanyl, thiophenyl, imidazolyl, pyrazolyl, oxazolyl, thiazolyl, pyrazinyl, ethenyl, propenyl, isopropenyl, butenyl, isobutenyl, pentenyl, hexenyl, heptenyl, 2-ethylhexenyl, octenyl, 3-allyloxy-2-hydroxypropyl, 3-allyloxy-2-acetoxypropyl, or the like. R₁ and R₂ may be the same or different, and R₃ and R₄ may be the same or different.

In formulae (1) and (2) for the organic peroxides, R₁ and R₃ are preferably optionally substituted alkyl groups of 1 to 18 carbon atoms.

In formula (1) for the organic peroxide, R₂ is preferably a tert-butyl group or a tert-hexyl group.

In formula (2) for the organic peroxide, R₄ is preferably an optionally substituted alkyl group of 1 to 18 carbon atoms.

Examples of the organic peroxide having the peroxyester structure of formula (1) include tert-butyl peroxyacetate, tert-hexyl peroxyacetate, tert-butyl peroxy-n-propionate, tert-hexyl peroxy-n-propionate, tert-butyl peroxy-2-methylbutanoate, tert-hexyl peroxy-2-methylbutanoate, tert-butyl peroxy-2-methylpentanoate, tert-hexyl peroxy-2-methylpentanoate, tert-butyl peroxy-n-hexanoate, tert-hexyl peroxy-n-hexanoate, tert-butyl peroxy-2-ethylhexanoate, tert-hexyl peroxy-2-ethylhexanoate, tert-butyl peroxy-3,5,5-trimethylhexanoate, tert-hexyl peroxy-3,5,5-trimethylhexanoate, tert-butyl peroxyoctanoate, tert-hexyl peroxyoctanoate, tert-butyl peroxylaurate, tert-hexyl peroxylaurate, tert-butyl peroxystearate, tert-hexyl peroxystearate, and the like. These may be used alone or in combination of two or more.

Examples of the organic peroxide having the peroxyester structure of formula (2) include 2,5-dimethyl-2,5-di(2-ethylhexanoylperoxy)hexane, 2,5-dimethyl-2,5-di(3,5,5-trimethylhexanoylperoxy)hexane, 2,5-dimethyl-2,5-di(n-octanoylperoxy)hexane, 2,5-dimethyl-2,5-di(n-dodecanoylperoxy)hexane, 2,5-dimethyl-2,5-di(n-octadecanoylperoxyyhexane, and the like. These may be used alone or in combination of two or more.

An appropriate mixture of the organic peroxides having the peroxyester structures of formulae (1) and (2), respectively, may also be used.

The encapsulant composition for a solar cell preferably contains 0.01 to 3 parts by weight, 0.03 to 2 parts by weight, 0.05 to 1.5 parts by weight, or 0.1 to 1 part by weight of the organic peroxide based on 100 parts by weight of the ethylenic copolymer.

In the encapsulant composition for a solar cell, the organic peroxide preferably has a one-minute half-life temperature of 155°C or higher, 158°C or higher, or 160°C or higher. When the organic peroxide with such a one-minute half-life temperature is used, crosslinking can be easily and/or reliably prevented during film formation. The organic peroxide preferably has a one-minute half-life temperature of 175°C or lower, 172°C or lower, or 170°C or lower. When the organic peroxide with such a one-minute half-life temperature is used, the organic peroxide can be sufficiently consumed during heat press bonding in a lamination process. The use of the organic peroxide makes it possible to particularly suppress yellowing, which would otherwise be more likely to occur when a benzophenone ultraviolet absorber, a benzotriazole ultraviolet absorber, a triazine ultraviolet absorber, a salicylic acid ultraviolet absorber, a cyanoacrylate ultraviolet absorber, or the like is used.

The encapsulant composition of the invention for a solar cell may be subjected to a manufacturing process that includes kneading the encapsulant composition at 80 to 110°C, forming the composition at 80 to 100°C into a sheet using a heat press machine or the like, and then crosslinking the resulting encapsulant sheet at 155 to 165°C for a crosslinking time of 15 minutes or less. In this manufacturing process, the use of the organic peroxide particularly effectively makes it possible to reduce the time required for the lamination process and to improve light resistance and resistance to moisture and heat. The kneading temperature may be 80 to 130°C, 90 to 100°C, or 110 to 120°C. The sheet forming temperature may be 80 to 130°C, 90 to 100°C, or 110 to 120°C. The crosslinking temperature may be 160 to 180°C, 145 to 155°C, or 160 to 170°C. The crosslinking time is preferably 15 minutes or less and may be 10 to 15 minutes, 15 to 20 minutes, or 20 to 30 minutes.

Alternatively, the manufacturing process may include, for example, kneading the encapsulant composition at 90 to 110°C, forming the composition at 70to 90°C into a sheet by calendering, and then crosslinking the resulting encapsulant sheet at 150 to 160°C for a crosslinking time of 18 minutes or less. Alternatively, the manufacturing process may include, for example, kneading the encapsulant composition at 70 to 100°C, forming the composition at 70 to 90°C into a sheet using a heat press machine, and then crosslinking the resulting encapsulant sheet at 140 to 150°C for a crosslinking time of 15 minutes or less. Alternatively, the manufacturing process may include, for example, kneading the encapsulant composition at 90 to 110°C, forming the composition at 70 to 110°C into a sheet by T-die casting, and then crosslinking the resulting encapsulant sheet at 160 to 180°C for a crosslinking time of 15 minutes or less.

In an organic peroxide, the peroxide bond and the electron state of the structure around the bond can influence not only the activation energy for the cleavage of the peroxy structure to form a radial but also its oxidizability. Concerning the peroxide bond, a peroxyester bond or a peroxide structure with a low electron density is considered to have relatively low oxidizability. On the other hand, the ethylenic copolymer film formation and the crosslinking of the resin composition including the ethylenic copolymer should be performed in appropriate temperature ranges in view of their processability. As a result of taking into account the production of a solar cell encapsulant sheet and the sheet lamination process, the invention provides newly found organic peroxides that are designed, by controlling a peroxyester bond linked to an alkyl group, to be useful on an industrial scale and less likely to cause oxidative degradation.

The encapsulant composition of the invention for a solar cell preferably contains 0.001 to 0.5 parts by weight, 0.1 to 1 part by weight, 0.01 to 0.05 parts by weight, or 0.005 to 0.01 parts by weight of an antioxidant based on 100 parts by weight of the ethylenic copolymer.

Any known appropriate antioxidant may be used. Examples of the antioxidant include phenolic antioxidants, phosphorus-containing antioxidants, sulfur-containing antioxidants, amine antioxidants, lactone antioxidants, vitamin E-type antioxidants, and the like. These compounds may be used alone or in combination of two or more.

In the encapsulant composition of the invention for a solar cell, the antioxidant preferably has an optionally substituted hydroxytoluene skeleton. The antioxidant having an optionally substituted hydroxytoluene skeleton may be, for example, a dibutylhydroxytoluene (BHT) derivative or the like.

Examples of the dibutylhydroxytoluene (BHT) derivative include dibutylhydroxytoluene (BHT) and compounds derived from dibutylhydroxytoluene (BHT) by chemically modifying one or more parts of dibutylhydroxytoluene (BHT). Examples of the dibutylhydroxytoluene (BHT) derivative include a neutralized salt of dibutylhydroxytoluene, such as a sodium or potassium salt thereof, and derivatives derived from dibutylhydroxytoluene by the partial substitution of the benzene ring or the alkyl group with a substituent or substituents. In particular, dibutylhydroxytoluene (BHT) is preferably used. These may be used alone or in combination of two or more.

Dibutylhydroxytoluene (BHT) has a molecular weight of 220. When the dibutylhydroxytoluene (BHT) derivative is used, the derivative preferably has a molecular weight of 220 to 500, more preferably 220 to 400, even more preferably 220 to 300. The molecular weight is measured by mass spectrometry.

The encapsulant composition of the invention for a solar cell may contain an ultraviolet-absorbing compound. The ultraviolet-absorbing compound may be an ultraviolet-absorbing compound capable of preventing UV-induced degradation, an ultraviolet-absorbing compound capable of imparting a wavelength-converting function, or the like as long as the crosslinkability, UV-cutting properties, and discoloration-preventing function of the solar cell encapsulant layer are not impaired.

Any known appropriate ultraviolet-absorbing compound may be used. Examples of the ultraviolet-absorbing compound include benzophenone-type, benzotriazole-type, triazine-type, salicylic acid-type, and cyanoacrylate-type ultraviolet-absorbing compounds. These compounds may be used alone or in combination of two or more.

Examples of the benzophenone-type ultraviolet-absorbing compound include 2,2'-dihydroxy-4,4'-di(hydroxymethyl)benzophenone, 2,2'-dihydroxy-4,4'-di(2-hydroxyethyl)benzophenone, 2,2'-dihydroxy-3,3'-dimethoxy-5,5'-di(hydroxymethyl)benzoph enone, 2,2'-dihydroxy-3,3'-dimethoxy-5,5'-di(2-hydroxyethyl)benzop henone, 2,2'-dihydroxy-3,3'-di(hydroxymethyl)-5,5'-dimethoxybenzoph enone, 2,2'-dihydroxy-3,3'-di(2-hydroxyethyl)-5,5'-dimethoxybenzop henone, 2,2-dihydroxy-4,4-dimethoxybenzophenone, and the like.

Examples of the benzotriazole-type ultraviolet-absorbing compound include 2-[2'-hydroxy-5'-(hydroxymethyl)phenyl]-2H-benzotriazole, 2-[2'-hydroxy-5'-(2-hydroxyethyl)phenyl]-2H-benzotriazole, 2-[2'-hydroxy-5'-(3-hydroxypropyl)phenyl]-2H-benzotriazole, 2-[2'-hydroxy-3'-methyl-5'-(hydroxymethyl)phenyl]-2H-benzot riazole, 2-[2'-hydroxy-3'-methyl-5'-(2-hydroxyethyl)phenyl]-2H-benzo triazole, 2-[2'-hydroxy-3'-methyl-5'-(3-hydroxypropyl)phenyl]-2H-benz otriazole, 2-[2'-hydroxy-3'-tert-butyl-5'-(hydroxymethyl)phenyl]-2H-be nzotriazole, 2-[2'-hydroxy-3'-tert-butyl-5'-(2-hydroxyethyl)phenyl]-2H-b enzotriazole, 2-[2'-hydroxy-3'-tert-butyl-5'-(2-hydroxyethyl)phenyl]-5-ch loro-2H-benzotriazole, 2-[2'-hydroxy-3'-tert-butyl-5'-(3-hydroxypropyl)phenyl]-2H-benzotriazole, 2-[2'-hydroxy-3'-tert-octyl-5'-hydroxymethyl)phenyl]-2H-be nzotriazole, 2-[2'-hydroxy-3'-tert-octyl-5'-(2-hydroxyethyl)phenyl]-2H-b enzotriazole, 2-[2'-hydroxy-3'-tert-octyl-5'-(3-hydroxypropyl)phenyl]-2H-benzotriazole, 2,2'-methylenebis[6-(2H-benzotriazol-2-yl)-4-(hydroxymethyl )phenol], 2,2'-methylenebis[6-(2H-benzotriazol-2-yl)-4-(2-hydroxyethy l)phenol], 2,2'-methylenebis[6-(5-chloro-2H-benzotriazol-2-yl)-4-(2-hy droxyethyl)phenol], 2,2'-methylenebis[6-(5-bromo-2H-benzotriazol-2-yl)-4-(2-hyd roxyethyl)phenol], 2,2'-methylenebis[6-(2H-benzotriazol-2-yl)-4-(3-hydroxyprop yl)phenol], 2,2'-methylenebis[6-(5-chloro-2H-benzotriazol-2-yl)-4-(3-hy droxypropyl)phenol], 2,2'-methylenebis[6-(5-bromo-2H-benzotriazol-2-yl)-4-(3-hyd roxypropyl)phenol], 2,2'-methylenebis[6-(2H-benzotriazol-2-yl)-4-(4-hydroxybuty l)phenol], 2,2'-methylenebis[6-(5-chloro-2H-benzotriazol-2-yl)-4-(4-hy droxybutyl)phenol], 2,2'-methylenebis[6-(5-bromo-2H-benzotriazol-2-yl)-4-(4-hyd roxybutyl)phenol], 3,3-{2,2'-bis[6-(2H-benzotriazol-2-yl)-1-hydroxy-4-(2-hydro xyethyl)phenyl]}propane, 2,2-{2,2'-bis[6-(2H-benzotriazol-2-yl)-1-hydroxy-4-(2-hydro xyethyl)phenyl]}butane, 2,2'-oxybis[6-(2H-benzotriazol-2-yl)-4-(2-hydroxyethyl)phen ol], 2,2'-bis[6-(2H-benzotriazol-2-yl)-4-(2-hydroxyethyl)phenol] sulfide, 2,2'-bis[6-(2H-benzotriazol-2-yl)-4-(2-hydroxyethyl)phenol] sulfoxide, 2,2'-bis[6-(2H-benzotriazol-2-yl)-4-(2-hydroxyethyl)phenol] sulfone, 2,2'-bis[6-(2H-benzotriazole-2-yl)-4-(2-hydroxyethyl)phenol] amine, and the like.

Examples of the triazine-type ultraviolet-absorbing compound include 2-(2-hydroxy-4-hydroxymethylphenyl)-4,6-diphenyl-s-triazine, 2-(2-hydroxy-4-hydroxymethylphenyl)-4,6-bis(2,4-dimethylphe nyl)-s-triazine, 2-[2-hydroxy-4-(2-hydroxyethyl)phenyl]-4,6-diphenyl-s-triaz ine, 2-[2-hydroxy-4-(2-hydroxyethyl)phenyl]-4,6-bis(2,4-dimethyl phenyl)-s-triazine, 2-[2-hydroxy-4-(2-hydroxyethoxy)phenyl]-4,6-diphenyl-s-tria zine, 2-[2-hydroxy-4-(2-hydroxyethoxy)phenyl]-4,6-bis(2,4-dimethy lphenyl)-s-triazine, 2-[2-hydroxy-4-(3-hydroxypropyl)phenyl]-4,6-diphenyl-s-tria zine, 2-[2-hydroxy-4-(3-hydroxypropyl)phenyl]-4,6-bis(2,4-dimethy lphenyl)-s-triazine, 2-[2-hydroxy-4-(3-hydroxypropoxy)phenyl]-4,6-diphenyl-s-tri azine, 2-(2-hydroxy-4-(3-hydroxypropoxy)phenyl]-4,6-bis(2,4-dimeth ylphenyl)-s-triazine, 2-[2-hydroxy-4-(4-hydroxybutyl)phenyl]-4,6-diphenyl-s-triaz ine, 2-[2-hydroxy-4-(4-hydroxybutyl)phenyl]-4,6-bis(2,4-dimethyl phenyl)-s-triazine, 2-[2-hydroxy-4-(4-hydroxybutoxy)phenyl]-4,6-diphenyl-s-tria zine, 2-[2-hydroxy-4-(4-hydroxybutoxy)phenyl]-4,6-bis(2,4-dimethy lphenyl)-s-triazine, 2-(2-hydroxy-4-hydroxymethylphenyl)-4,6-bis(2-hydroxy-4-met hylphenyl)--s-triazine, 2-[2-hydroxy-4-(2-hydroxyethyl)phenyl]-4,6-bis(2-hydroxy-4-methylphenyl)--s-triazine, 2-(2-hydroxy-4-(2-hydroxyethoxy)phenyl]-4,6-bis(2-hydroxy-4 -methylphenyl)--s-triazine, 2-[2-hydroxy-4-(3-hydroxypropyl)phenyl]-4,6-bis(2-hydroxy-4 -methylphenyl)--s-triazine, 2-[2-hydroxy-4-(3-hydroxypropoxy)phenyl]-4,6-bis(2-hydroxy-4-methylphenyl)-s-triazine, 2-[4,6-bis(2,4-dimethylphenyl)-1,3,5-triazin-2-yl]-5-(octyl oxy)phenol, 2-(4,6-diphenyl-1,3,5-triazin-2-yl)-5-[(hexyl)oxy]phenol, and the like.

Examples of the salicylic acid-type ultraviolet-absorbing compound include phenyl salicylate, p-tert-butylphenyl salicylate, p-octylphenyl salicylate, and the like.

Examples of the cyanoacrylate-type ultraviolet-absorbing compound include 2-ethylhexyl 2-cyano-3,3'-diphenylacrylate, ethyl 2-cyano-3,3'-diphenylacrylate, and the like.

When the ultraviolet-absorbing compound used has a wavelength-converting function, the ultraviolet-absorbing compound may be a fluorescent compound capable of absorbing light in the wavelength region of 350 to 400 nm more than light in the wavelength region of more than 400 nm. Such a fluorescent compound may be any of an organic fluorescent compound and an inorganic fluorescent compound.

The organic fluorescent compound may be a known organic dye compound (such as an organic fluorescent dye). Examples of the organic fluorescent compound include naphthalimide, perylene, anthraquinone, coumarin, benzocoumarin, xanthene, phenoxazine, benzo[a]phenoxazine, benzo[b]phenoxazine, benzo[c]phenoxazine, naphthalimide, nathtolactam, azlactone, methine, oxazine, thiazine, diketopyrrolopyrrole, quinacridone, benzoxanthene, thioepindoline, lactamimide, diphenylmaleimide, acetoacetamide, imidazothiazine, benzanthrone, perylene monoimide, phthalimide, benzotriazole, benzothiazole, benzoxazole, pyrimidine, pyrazine, triazole, dibenzofuran, triazine, barbituric acid derivatives, and the like. These compounds may be used alone or in combination of two or more.

Examples of the inorganic fluorescent compound include complex compounds having europium or samarium as an emission center. These compounds may be used alone or in combination of two or more.

For example, the fluorescent compound preferably has an absorbance of 0.1 to 6, more preferably 0.5 to 4, even more preferably 0.8 to 3.

The ultraviolet-absorbing compound preferably has a maximum absorption wavelength in the range of 200 to 400 nm, in particular, in the range of 280 to 380 nm. The ultraviolet-absorbing compound with such a maximum absorption wavelength can more effectively absorb an ultraviolet component of the applied light, which would otherwise cause photodegradation of the ethylenic copolymer such as the ethylene-vinyl acetate copolymer and an organic material such as a back sheet. The maximum absorption wavelength of the ultraviolet-absorbing compound can be measured by a known technique with a commercially available ultraviolet measurement system or the like.

Among the above ultraviolet-absorbing compounds, the benzophenone-type ultraviolet-absorbing compound, specifically, the benzophenone-type ultraviolet-absorbing compound containing at most two hydroxyl groups per molecule is preferably used particularly in order to prevent photodegradation of the ethylenic copolymer and an organic material such as a back sheet. Examples of the preferred ultraviolet-absorbing compound include 2-hydroxy-4-methoxybenzophenone, 2,4-dihydroxybenzophenone, 2-hydroxy-4-n-octoxybenzophenone, and the like. These compounds have a maximum absorption wavelength in the range of 320 to 350 nm and can more effectively prevent photodegradation of the ethylene-vinyl acetate copolymer.

The content of the ultraviolet-absorbing compound is preferably 0.01 to 2 parts by weight, 0.05 to 1 part by weight, or 0.1 to 0.5 parts by weight based on 100 parts by weight of the ethylenic copolymer.

The ultraviolet-absorbing compound may be a fluorescent dye compound having a carbon-carbon double bond group. Such a fluorescent dye compound may be used as a monomer and copolymerized in the polymerization for the ethylenic copolymer or in an addition reaction after the polymerization so that a luminescent ethylenic copolymer resin can be formed and used.

The encapsulant composition for a solar cell may contain any known appropriate additive as long as the desired performance is not impaired. The additive may be, for example, a thermoplastic polymer, a light stabilizer, an organic peroxide, a filler, a plasticizer, a silane coupling agent, an acid acceptor, clay, or the like. These additives may be used alone or in combination of two or more.

Any known appropriate light stabilizer maybe used. Such a light stabilizer may be a compound having the function of scavenging radical species harmful to the polymer and preventing the generation of new radicals. Such a light stabilizer may be, for example, a hindered amine light stabilizer (HALS) or the like. Examples of the hindered amine light stabilizer include a low-molecular-weight hindered amine light stabilizer, a high-molecular-weight hindered amine light stabilizer, an N-alkyl hindered amine light stabilizer, and an N-H hindered amine light stabilizer. These compounds may be used alone or in combination of two or more. The addition of the light stabilizer can prevent the yellowing of the solar cell encapsulant film, which would otherwise be caused by the degradation of the matrix resin due to the influence of applied light and the like.

Examples of the low-molecular-weight hindered amine light stabilizer include a mixture of 70% by weight of a product (molecular weight 737) of reaction of bis(2,2,6,6-tetramethyl-1(octyloxy)-4-piperidinyl decanedioate, 1,1-dimethylethyl hydroperoxide, and octane and 30% by weight of polypropylene; bis (1,2,2,6,6-pentamethyl-4-piperidyl)[[3,5-bis (1,1-dimethy lethyl)-4-hydroxyphenyl]methyl]butyl malonate (molecular weight 685); a mixture (molecular weight 509) of bis(1,2,2,6,6-pentamethyl-4-piperidyl) sebacate and methyl-1,2,2,6,6-pentamethyl-4-piperidyl sebacate; bis(2,2,6,6-tetramethyl-4-piperidyl) sebacate (molecular weight 481); tetrakis(2,2,6,6-tetramethyl-4-piperidyl)-1,2,3,4-butanetet racarboxylate (molecular weight 791); tetrakis(1,2,2,6,6-pentamethyl-4-piperidyl)-1,2,3,4-butanet etracarboxylate (molecular weight 847); a mixture (molecular weight 900) of 2,2,6,6-tetramethyl-4-piperidyl-1,2,3,4-butanetetracarboxyl ate and tridecyl-1,2,3,4-butanetetracarboxylate; a mixture (molecular weight 900) of 1,2,2,6,6-pentamethyl-4-piperidyl-1,2,3,4-butanetetracarbox ylate and tridecyl-1,2,3,4-butanetetracarboxylate; and the like.

Examples of the high-molecular-weight hindered amine light stabilizer include poly[{6-(1,1,3,3-tetramethylbutyl)amino-1,3,5-triazin-2,4-d iyl}{(2,2,6,6-tetramethyl-4-piperidyl)imino}hexamethylene{( 2,2,6,6-tetramethyl-4-piperidyl)imino}] (molecular weight 2,000 to 3,100); a polymer (molecular weight 3,100 to 4,000) of dimethyl succinate and 4-hydroxy-2,2,6,6-tetramethyl-1-piperidine ethanol; a mixture of polymers of N,N',N",N'"-tetrakis(4,6-bis(butyl-(N-methyl-2,2,6,6-tetr amethylpiperidin-4-yl)amino)triazin-2-yl)-4,7-diazadecane-1 ,10-diamine (molecular weight 2,286), dimethyl succinate, and 4-hydroxy-2,2,6,6-tetramethyl-1-piperidine ethanol; a polycondensate (molecular weight 2,600 to 3,400) of dibutylamine-1,3,5-triazine-N,N'-bis(2,2,6,6-tetramethyl-4-piperidyl)-1,6-hexamethlenediamine and N-(2,2,6,6-tetramethyl-4-piperidyl)butylamine; and the like.

Commercially available products of the hindered amine light stabilizer include LA-52, LA-57, LA-62, LA-63, LA-63p, LA-67, and LA-68 (all manufactured by ADEKA CORPORATION), Tinuvin 744, Tinuvin 770, Tinuvin 765, Tinuvin 123, Tinuvin 144, Tinuvin 622LD, and CHIMASSORB 944LD (all manufactured by BASF), UV-3034 (manufactured by B. F. Goodrich Corporation), and the like.

The encapsulant composition for a solar cell can be produced according to known methods. For example, the encapsulant composition may be obtained by a process of mixing the materials by a known method using heating and kneading means, a super mixer (high-speed fluidizing mixer), a roll mill, a plasto mill, or the like. The mixing and the subsequent production of the encapsulant layer may be performed continuously.

### Solar cell encapsulant layer

The solar cell encapsulant layer of the invention is made from the encapsulant composition for a solar cell. The encapsulant layer may have a wavelength-converting function (a wavelength-converting encapsulant layer).

The encapsulant layer may be produced according to known methods. For example, the encapsulant layer can be appropriately produced by a process that includes mixing the materials by a known method using heating and kneading means, a super mixer (high-speed fluidizing mixer), a roll mill, a plasto mill, or the like; and forming the resulting composition into a sheet-shaped product by conventional extrusion, calender forming (calendering), vacuum heating and pressing, or the like. Alternatively, the layer can be produced by a process that includes forming the layer on a PET film or the like and then transferring the layer onto a surface protective layer. Alternatively, the layer can be produced using a process that includes simultaneously performing the kneading of the materials, the melting of the mixture, and the applying of the mixture with a hot melt applicator.

More specifically, the encapsulant composition containing the ethylenic copolymer may be directly applied to a surface protective layer, a separator, or the like, or a mixed composition of the material and other materials may be formed and applied. The encapsulant composition may also be formed by vapor deposition, sputtering, aerosol deposition, or the like.

When the mixed composition is applied, the encapsulant composition preferably has a melting point of 50 to 250°C, more preferably 50 to 200°C, even more preferably 50 to 180°C in view of workability. When the encapsulant composition has a melting point of 50 to 250°C, the composition is preferably kneaded, melted, and applied at a temperature 30 to 100°C higher than the melding point.

In some embodiments, the encapsulant layer is formed as a thin film structure by the steps of: (i) dissolving a power of the ethylenic copolymer (and the other matrix resin) at a predetermined concentration in a solvent (such as tetrachloroethylene (TCE), cyclopentanone, or dioxane) to form a polymer solution; (ii) forming a polymer thin film by casting the polymer solution directly on a glass substrate, then heating the substrate from room temperature up to 100°C over 2 hours, and completely removing the residual solvent by additional vacuum heating at 130°C overnight; and (iii) peeling off the polymer thin film in water and then completely drying the self-supported polymer film before use, wherein (iv) the thickness of the film can be controlled by changing the concentration of the polymer solution and the evaporation rate.

The encapsulant layer preferably has a thickness of 20 to 2, 000 µm, more preferably 50 to 1,000 µm, even more preferably 100 to 800 µm. If its thickness is less than 5 µm, power generation cells may crack during the lamination process. If its thickness is more than 700 µm, it may be disadvantageous in terms of cost.

Particularly when having a wavelength-converting function, the encapsulant layer preferably has a maximum absorption wavelength of 300 to 410 nm, 330 to 370 nm, or 340 to 360 nm.

Particularly when having a wavelength-converting function, the encapsulant layer preferably has a maximum fluorescence wavelength of 400 to 560 nm, 405 to 490 nm, or 410 to 470 nm.

For example, the encapsulant layer preferably has an absorbance of 0.5 to 6, more preferably 0.8 to 4, even more preferably 1 to 3.

The encapsulant layer typically has a refractive index in the range of 1.4 to 1.7, 1.45 to 1.65, or 1.45 to 1.55. In some embodiments, the encapsulant composition has a refractive index of 1.5.

### Solar cell module

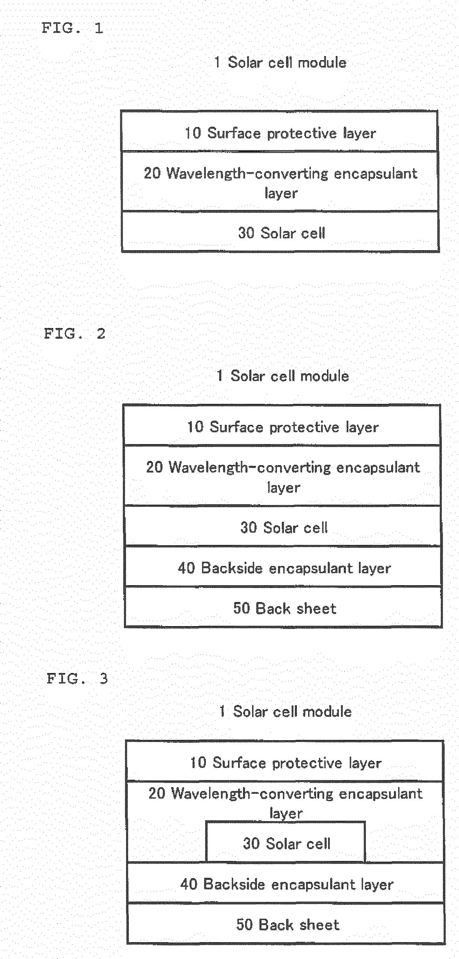

The solar cell module 1 of the invention includes the encapsulant layer 20 and a solar cell 30. Figs. 1 and 2 are simple schematic diagrams each showing an example of the solar cell module of the invention, which, however, are not intended to limit the invention. A surface protective layer 10, an additional encapsulant layer 40 on the backside of the solar cell, and a back sheet 50 may also be provided as needed. An additional layer such as an adhesive layer or a pressure-sensitive adhesive layer may be placed as needed between each pair of the layers as long as the function of the solar cell encapsulant layer is not impaired. If necessary, each of the encapsulant layers may also be a wavelength-converting encapsulant layer containing the ultraviolet-absorbing compound.

The solar cell module having the encapsulant layer allows the reduction of the time required for the lamination process and also allows the improvement of light resistance and resistance to moisture and heat. When the wavelength-converting encapsulant layer is used, a wavelength usually not contributable to the photoelectric conversion can be converted to another wavelength contributable to the photoelectric conversion. Specifically, a certain wavelength can be converted to a longer wavelength. For example, a wavelength shorter than 370 nm can be converted to a wavelength of 370 nm or more. In particular, a wavelength in the ultraviolet region (10 nm to 365 nm) can be converted to a wavelength in the visible light region (370 nm to 800 nm). The wavelength range contributing to photoelectric conversion varies with the type of solar cell, and, for example, even among silicon solar cells, it varies with the crystal morphology of the silicon used. For example, it is thought to be 400 to 700 nm in the case of amorphous silicon solar cells and to be about 600 to 1,100 nm in the case of polycrystalline silicon solar cells. Therefore, wavelengths contributing to the photoelectric conversion are not necessarily in the visible light region.

The solar cell may be, for example, a crystalline silicon solar cell, an amorphous silicon solar cell, a microcrystalline silicon solar cell, a thin-film silicon solar cell, a heterojunction solar cell, a multi-junction solar cell, a cadmium sulfide/cadmium telluride solar cell, a CIS thin-film solar cell, a CIGS thin-film solar cell, a CZTS thin-film solar cell, a group III-V solar cell, a dye-sensitized solar cell, or an organic semiconductor solar cell. The solar cell is preferably a crystalline silicon solar cell.

In the process of manufacturing the solar cell module, the solar cell encapsulant layer may be transferred onto the solar cell or the like or formed directly on the solar cell by coating. The solar cell encapsulant layer and other layers may also be formed at the same time.

In the solar cell module of the invention, the wavelength-converting encapsulant layer is preferably so disposed that incident light passes through the wavelength-converting encapsulant layer before reaching the solar cell. In this structure, a wider spectrum of solar energy can be more reliably converted to electricity, so that the photoelectric conversion efficiency can be effectively increased.

The surface protective layer may be a known surface protective layer used in solar cell applications. The surface protective layer may be, for example, a front sheet, a glass layer, or the like. The glass layer may be any of various appropriate glass materials such as super white glass and embossed or non-embossed glass.

### Examples

Hereinafter, examples and so on will be described to show the features and effects of the invention specifically.

### Method for preparing encapsulant sheets

### Examples 1 to 6 and Comparative Examples 1 to 3

To a commercially available EVA resin were added 0.3 parts by weight of an organic peroxide as a crosslinking agent, 0.3 parts by weight of a silane coupling agent (γ-methacryloxypropyltrimethoxysilane), 1 part by weight of a crosslinking aid (triallyl isocyanurate), 0,04 parts by weight of an antioxidant (dibutylhydroxytoluene (BHT)), 0.2 parts by weight of SS130 or PA680 as an ultraviolet absorber, and 0.04 parts by weight of TN765 or TN144 as a hindered amine light stabilizer. The mixture was kneaded at 110°C and then formed at 100 °C into a sheet using a heat press machine, so that a solar cell encapsulant sheet was obtained.

### Comparative Example 4

To a commercially available EVA resin were added 0.15 parts by weight of PB-E as a crosslinking agent, 1.5 parts by weight of PH-25B as a crosslinking agent, 0.3 parts by weight of a silane coupling agent (γ-methacryloxypropyltrimethoxysilane), 1 part by weight of a crosslinking aid (triallyl isocyanurate), 0.04 parts by weight of an antioxidant (dibutylhydroxytoluene (BHT)), 0.2 parts by weight of SS130 as an ultraviolet absorber, and 0.04 parts by weight of TN144 as a hindered amine light stabilizer. The mixture was kneaded at 110°C and then formed at 100 °C into a sheet using a heat press machine, so that a solar cell encapsulant sheet was obtained.

### Method for preparing samples for evaluation

The resulting encapsulant sheet (500 µmin thickness) was sandwiched between two glass sheets or between a glass sheet and a back sheet. They were bonded together under the conditions of 80 °C and 100 kN and then stored under conditions at 160 °C in a drying oven for 15 minutes. The resulting laminate sample was then subjected to evaluation for light stability and degree of yellowing.

### Method for evaluating light stability

The sample with glass on both sides was irradiated with 1 W/cm² of UV light (365 nm) for a certain period of time (120 minutes) using a UV irradiator (UJ35 manufactured by Panasonic Corporation) and a lens. After the UV light irradiation, the absorption spectrum of the sample was measured with a spectrophotometer (V560 manufactured by JASCO Corporation). The change in the top of the absorption peak of the organic compound was evaluated based on the resulting spectral information.

### Method for evaluating yellowing

The laminate sample with the glass and back sheets was stored for 1,000 hours in an environmental testing machine set at a temperature of 85°C and a relative humidity of 85%. Before and after the storage, the reflection spectrum of the sample was measured with an MCPD (manufactured by Otsuka Electronics Co., Ltd.). The degree of yellowing (YI: Yellow Index, ASTM D1925) was calculated from the difference between the resulting reflection spectrum information before the storage and that after the storage.

### Examples

### Organic peroxides having peroxyester structure

Tert-butyl peroxy-3,5,5-trimethylhexanoate (PERBUTYL 355 (PB-355) manufactured by NOF CORPORATION)
Tert-butyl peroxylaurate (PERBUTYL L (PB-L) manufactured by NOF CORPORATION)
Tert-hexyl peroxyacetate (PERHEXYLA (PH-A) manufactured by NOF CORPORATION)

### Comparative Examples

Organic peroxides having other structures
2,5-dimethyl-2,5-di(tert-butylperoxy)hexane (PERHEXA 25B (PH-25B) manufactured by NOF CORPORATION)
Tert-butyl peroxy-2-ethylhexylmonocarbonate (HERBUTYL E (PB-E) manufactured by NOF CORPORATION)
1,1-di(tert-hexylperoxy)cyclohexane (PERHEXA HC (PH-HC) manufactured by NOF CORPORATION)

### Ultraviolet absorbers

2-hydroxy-4-n-octoxybenzophenone (Sumisorb 130 (SS130) manufactured by Sumitomo Chemical Company, Limited)
4,7-bis(4-tert-butylphenyl)-2-isobutyl-2H-benzotriazo le (PA680 manufactured by Nitto Denko Corporation)

### Hindered amine light stabilizer

Bis(1,2,2,6,6-pentamethyl-4-piperidyl) sebacate (Tinuvin 765 (TN765))
Bis(1,2,2,6,6-pentamethyl-4-piperidinyl) 2-[[3,5-bis(1,1.-dimethylethyl)-4-hydroxyphenyl]methyl-2-but yl propanedioate (Tinuvin 144 (TN144)).

**[Table 1]**

| | Example 1 | Example 2 | Example 3 | Example 4 | Example 5 | Example 6 | Comparative Example 1 | Comparative Example 2 | Comparative Example 3 | Comparative Example 4 |
|---|---|---|---|---|---|---|---|---|---|---|
| Organic peroxide (One-minute half-life temperature) | PB-355 (166°C) | PB-355 (166°C) | PB-355 (166°C) | PB-355 (166°C) | PB-L (159°C) | PH-A (155°C) | PB-E (161°C) | PH-25B (179°C) | PH-HC (149°C) | PB-E+ PH-25B |
| Ultraviolet absorber | SS130 | SS130 | PA680 | PA680 | SS130 | SS130 | SS130 | SS130 | SS130 | SS130 |
| HALS | TN765 | TN144 | TN765 | TN144 | Tri 4 | TN194 | TN144 | TN144 | TN144 | TN144 |
| Light stability | 8% | 7% | 9% | 4% | 9% | 8% | 28% | 10% | 8% | 9% |
| Degree of yellowing | 1.2 | 1.7 | 1.1 | 1.8 | 1.9 | 2.0 | 4.1 | 7.2 | 8.2 | 2.8 |

- 1: Solar cell module
- 10: Surface protective layer
- 20: Wavelength-converting encapsulant layer
- 30: Solar cell
- 40: Backside encapsulant layer
- 50: Back sheet

## Claims

1. A encapsulant composition for a solar cell, comprising:
an ethylenic copolymer; and
an organic peroxide having a peroxyester structure represented by formula (1) : 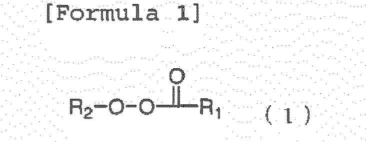 or formula (2): 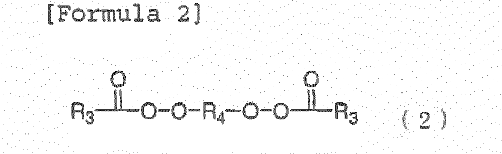 wherein R₁, R₂, R₃, and R₄ each independently represent an optionally substituted alkyl group of 1 to 18 carbon atoms or an optionally substituted aryl group of 5 to 18 carbon atoms.

2. The encapsulant composition according to claim 1 for a solar cell, wherein in formulae (1) and (2), R₁ and R₃ are optionally substituted alkyl groups of 1 to 18 carbon atom.

3. The encapsulant composition according to claim 1 or 2 for a solar cell, wherein in formulae (1), R₂ is a tert-butyl group or a tert-hexyl group.

4. The encapsulant composition according to any one of claims 1 to 3 for a solar cell, wherein in formulae (2), R₄ is an optionally substituted alkyl group of 1 to 18 carbon atoms.

5. The encapsulant composition according to any one of claims 1 to 4 for a solar cell, which comprises 100 parts by weight of the ethylenic copolymer and 0.01 to 3 parts by weight of the organic peroxide.

6. The encapsulant composition according to any one of claims 1 to 5 for a solar cell, further comprising 0.001 to 0.5 parts by weight of an antioxidant based on 100 parts by weight of the ethylenic copolymer.

7. The encapsulant composition according to claim 6 for a solar cell, wherein the antioxidant has an optionally substituted hydroxytoluene skeleton.

8. The encapsulant composition according to any one of claims 1 to 7 for a solar cell, further comprising an ultraviolet-absorbing compound.

9. A solar cell encapsulant layer comprising a product made from the encapsulant composition according to any one of claims 1 to 8 for a solar cell.

10. A solar cell module comprising the solar cell encapsulant layer according to claim 9 and a solar cell.

11. The solar cell module according to claim 10, wherein the solar cell is a crystalline silicon solar cell, an amorphous silicon solar cell, a microcrystalline silicon solar cell, a thin-film silicon solar cell, a heterojunction solar cell, a multi-junction solar cell, a cadmium sulfide/cadmium telluride solar cell, a CIS thin-film solar cell, a GIGS thin-film solar cell, a CZTS thin-film solar cell, a group III-V solar cell, a dye-sensitized solar cell, or an organic semiconductor solar cell.
